# EUROPÄISCHE PATENTANMELDUNG

(11) **EP 0 710 889 A2**
(43) Veröffentlichungstag der Anmeldung: **08.05.1996**
(21) Anmeldenummer: 95116657.8
(22) Anmeldetag: 23.10.1995
(51) Int. Cl.: G03F 7/11

(54) **Lichtempfindliches Aufzeichnungsmaterial**

(30) Priorität: 03.11.1994 DE 4439184
(71) Anmelder: HOECHST AKTIENGESELLSCHAFT, D-65926 Frankfurt am Main (DE)
(72) Erfinder: Elsässer, Dr. Andreas, D-65510 Idstein (DE); Gaschler, Otfried, D-65205 Wiesbaden (DE); Frass, Werner, Dr., D-65207 Wiesbaden (DE); Konrad, Klaus Peter, Dr., D-55218 Ingelheim (DE)

(57) **Zusammenfassung**

Es wird ein lichtempfindliches Aufzeichnungsmaterial mit einem Schichtträger, einer negativ arbeitenden lichtempfindlichen Schicht, die ein Diazoniumsalz und ein wasserunlösliches, in wäßrig-alkalischen Lösungen lösliches oder quellbares polymeres Bindemittel enthält, und einer diskontinuierlichen, eine rauhe Oberfläche bildenden Deckschicht beschrieben, die aus Partikeln eines wasserunlöslichen, in Wasser in Gegenwart von anionischen oder anionisch/nichtionischen Dispergiermitteln dispergierbaren Polymeren mit einem Gehalt an freien oder durch Salzbildung neutralisierten Säuregruppen von weniger als 0,8 mol/g besteht, wobei die mittlere Höhe der Partikel 2 bis 6 µm, die maximale Höhe kleiner als 10 µm, der mittlere horizontale Durchmesser kleiner als 40 µm, der maximale Durchmesser kleiner als 80 µm ist und die Anzahl der Partikel 100 bis 10000 je cm² beträgt. Das Material ist zur Herstellung von Flachdruckplatten geeignet und erfordert nur kurze Ansaugzeiten im Vakuumkopierrahmen. Das Material läßt sich nach dem Belichten rückstandsfrei entwickeln, wobei die rauhe Oberfläche an den Bildstellen erhalten bleibt.

## Beschreibung

Die Erfindung betrifft ein Aufzeichnungsmaterial, insbesondere für die Herstellung von Flachdruckplatten, mit einem Schichtträger, einer lichtempfindlichen Schicht, die ein Diazoniumsalz und ein in Wasser unlösliches, in wäßrig-alkalischen Lösungen lösliches, organisches, polymeres Bindemittel enthält, und einer darauf befindlichen, diskontinuierlichen, eine rauhe Oberfläche bildenden Deckschicht.

Der erste Schritt bei der Herstellung von Flachdruckplatten ist üblicherweise das bildmäßige Belichten des lichtempfindlichen Aufzeichnungsmaterials in einem Vakuum-Kontaktkopierrahmen. Dabei soll die Vorlage möglichst rasch in engen Kontakt zu dem Aufzeichnungsmaterial gebracht werden. Nach dem Evakuieren sollen keine Lufteinschlüsse zwischen Vorlage und Aufzeichnungsmaterial zurückbleiben. Auch der während des Belichtens aus dem Diazoniumsalz freigesetzte Stickstoff soll möglichst rasch abgeführt werden, damit sich keine Stickstoffeinschlüsse bilden. Beide Forderungen lassen sich mit einem Aufzeichnungsmaterial, dessen lichtempfindliche Schicht oberflächlich aufgerauht ist, erfüllen. Eine rauhe Oberfläche kann beispielsweise durch Bestäuben vor dem bildmäßigen Bestrahlen erzielt werden. Ein solches Verfahren erzeugt jedoch meist ungleichmäßig aufgerauhte Oberflächen, so daß auch ungleichmäßige Kopierresultate erzielt werden.

Die Hersteller der lichtempfindlichen Aufzeichnungsmaterialien haben sich daher bemüht, ihre Produkte bereits mit einer definiert rauhen Oberfläche zu versehen. Dabei kamen verschiedene Verfahren zum Einsatz. So kann das Trägermaterial mit einer lichtempfindlichen Lösung beschichtet werden, in der wasserlösliche Partikel suspendiert sind, die nach dem Trocknen der Schicht mit Wasser ausgewaschen werden. Die Oberfläche der lichtempfindlichen Schicht weist danach eine Vielzahl an Vertiefungen auf.

Eine rauhe Oberfläche kann auch durch Auftragen von durchgehenden oder diskontinuierlichen Mattierungsschichten erreicht werden. So ist in der DE-A 30 09 928 (= GB-A 2 046 461) ein Verfahren beschrieben, bei dem eine lichtempfindliche Schicht mit einer nicht lichtempfindlichen Beschichtungsflüssigkeit überzogen wird, die in dispergierter Form Teilchen aus Polyethylen, Polypropylen, Ethylen/Propylen-Copolymeren, Ethylen/Vinylacetat-Copolymeren, Polyethylenterephthalat oder einem vernetzten Vinylpolymeren enthält. Nach dem Trocknen verbleiben die einzelnen Teilchen als sehr kleine Vorsprünge in der durchgehenden Deckschicht.

Durchgehende oder diskontinuierliche Deckschichten mit definierter Oberflächenrauhheit lassen sich mit Hilfe einer Prägewalze auftragen. Die dafür verwendeten Beschichtungslösungen können konventionelle Mattierungsmittel, wie Siliciumdioxid, Zinkoxid, Titandioxid, Glasperlen, Aluminiumoxid, Stärke, Poly(methylmethacrylat), Polystyrol und Phenolharze, enthalten (DE-A 26 06 793 = GB-A 1 542 131).

Aus der DE-A 31 31 570 (= GB-A 2 081 919) ist ein Aufzeichnungsmaterial mit einer lichtempfindlichen Schicht und einer darauf befindlichen Mattierungsschicht bekannt. Die Mattierungsschicht wird durch Aufsprühen und Trocknen einer wäßrigen Lösung oder Dispersion, in der ein organisches Copolymeres enthalten ist, aufgetragen. Das Aufsprühen kann auch elektrostatisch erfolgen. Die lichtempfindliche Schicht kann ein 1,2-Naphthochinon-2-diazid und ein polymeres Bindemittel enthalten. Wie Beispiel 1 zeigt, müssen die Mattierungsschichten beim Entwickeln entfernbar sein. Eine Mattierungsschicht mit Copolymeren, die einen Gehalt an Polymereinheiten mit Salzgruppen von 12 Gew.-% oder mehr aufweist, erfüllt diese Bedingung. Wird jedoch ein Copolymeres mit nur 4 Gew.-% an Na-Acrylat-Einheiten verwendet, so wird die Mattierung nicht mehr vollständig entfernt, und es treten als Folge davon Verfärbungen (Fleckenbildung) beim Drucken auf.

In der DE-A 34 33 247 (= US-A 4 842 982) ist ein licht- bzw. strahlungsempfindliches Aufzeichnungsmaterial beschrieben, bei dem auf die strahlungsempfindliche Schicht eine rauhe Deckschicht aufgesprüht und getrocknet wird. Beide Schichten haben im wesentlichen die gleiche Zusammensetzung. Wird das Aufzeichnungsmaterial nur kurz belichtet, wie es für Feinrasterarbeiten erforderlich sein kann, so verbleiben nach dem Entwickeln häufig noch Reste der Schicht in den Nichtbildbereichen. Diese müssen dann in einem zusätzlichen Korrekturschritt entfernt werden.

Eine weitere Möglichkeit, ein mattiertes, lichtempfindliches Aufzeichnungsmaterial herzustellen, besteht darin, in die lichtempfindliche Schicht feinteilige Partikel einzubringen, deren kleinste Abmessung mindestens so groß ist wie die Dicke der Schicht. Die Partikel können anorganischer oder organischer Natur sein (DE-A 29 26 236 = CA-A 1 148 014). Thermisch gehärtete Phenolharze werden als besonders geeignet beschrieben (DE-A 31 17 702 = GB-A 2 075 702).

Ein Aufzeichnungsmaterial, in dem die lichtempfindliche Schicht selbst mattiert ist, bietet den Vorteil, daß nach bildmäßiger Belichtung und nachfolgender Entwicklung die Mattierung an den Bildstellen erhalten bleibt. Die beschriebenen separaten Mattierungsschichten sind dagegen im Entwickler löslich oder dispergierbar und werden praktisch vollständig entfernt. Um die Mattierungsteilchen in der lichtempfindlichen Schicht herum kann jedoch eine Hofbildung auftreten. Auch können die Mattierungsteilchen Agglomerate bilden.

Es bestand somit die Aufgabe, ein mattiertes, lichtempfindliches Aufzeichnungsmaterial bereitzustellen, das die Nachteile der bekannten Materialien nicht aufweist. Insbesondere sollte es in den Nichtbildstellen rückstandsfrei entwickelbar sein. An den Bildstellen sollte die Mattierung dagegen erhalten bleiben.

Gegenstand der vorliegenden Anmeldung ist somit ein Aufzeichnungsmaterial mit einem Schichtträger, einer lichtempfindlichen Schicht, die ein Diazoniumsalz und ein in Wasser unlösliches, in wäßrig-alkalischen Lösungen lösliches oder quellbares organisches polymeres Bindemittel enthält, und einer diskontinuierlichen, eine rauhe Oberfläche bildenden Deckschicht.

Das erfindungsgemäße Material ist dadurch gekennzeichnet, daß die Deckschicht aus Partikeln eines wasserunlöslichen, in Wasser in Gegenwart von anionischen oder anionisch/nichtionischen Dispergiermitteln dispergierbaren Polymeren mit einem Gehalt an freien oder durch Salzbildung neutralisierten Säuregruppen von weniger als 0,8 mmol/g besteht, wobei die mittlere Höhe der Partikel 2 bis 6 µm, die maximale Höhe kleiner als 10 µm, der mittlere horizontale Durchmesser kleiner als 40 µm, der maximale Durchmesser kleiner als 80 µm ist und die Anzahl der Partikel 100 bis 10000 je cm² beträgt.

Für die Deckschicht besonders geeignete Polymere sind solche, die Sulfo-, Carboxy- und/oder Phosphonogruppen entweder in freier Form oder als Salz mit einem ein- oder mehrwertigen Kation enthalten. Wesentlich ist, daß der Gehalt an Säure- und/oder Salzgruppen nicht mehr als 0,8 mmol/g beträgt. Liegt er darüber, so wird die Mattierung an den Bildstellen beim Entwickeln mit entfernt. Bei einem Gehalt an Säure- und/oder Salzgruppen im Polymeren unter 0,01 mmol/g ist ein anionischer Stabilisator zwingend erforderlich, da sonst oleophile Schichtreste in den Nichtbildstellen verbleiben, die beim Druck Farbe annehmen und sogenannte "spots" bilden.

Bevorzugt werden Polymere mit einem Gehalt an Säure- und/oder Salzgruppen von 0,03 bis 0,75 mmol/g. Auch bei diesen Polymeren wird im allgemeinen eine mindestens teilweise Neutralisation der Säuregruppen bevorzugt.

Die Kationen in den genannten Salzen sind insbesondere Na⁺, K⁺, NH₄⁺, Ca²⁺, Zn²⁺ oder Al³⁺. Die Polymeren sind gewöhnlich Polykondensations- oder Polyadditionsverbindungen. Geeignete Polymere sind beispielsweise Polyester, Polyamide, Polyurethane oder Polyharnstoffe, die die genannte molare Menge an Säure- und/oder Salzgruppen aufweisen. Dabei sind die Säure- oder Salzgruppen in der Regel an die Diol- oder Diamin-Einheiten in diesen Polymeren gebunden.

Geeignet sind auch Copolymere mit a) Einheiten aus Acrylsäure, Methacrylsäure, Itaconsäure, Maleinsäure, Ethylensulfonsäure (= Vinylsulfonsäure), Styrolsulfonsäure, 2-Acryloylamino-1,1-dimethyl-ethansulfonsäure, Vinylphosphonsäure, und/oder 2-Acryloylamino-1,1-dimethyl-ethylphosphonsäure (= Acrylamido-isobutylphosphonsäure) sowie deren Salzen und b) Einheiten aus Acrylsäureestern, Methacrylsäureestern, Acrylamiden, Methacrylamiden, Styrol, Vinylestern und/oder Vinylethern. Die Einheiten (a) können auch aus Phosphinsäuren, wie Methyl-vinyl-phosphinsäure, stammen. Die molare Menge der Einheiten (a) mit Säure- oder Salzgruppen wird auch in den Polyadditionsverbindungen so gewählt, daß die Polymeren je Gramm bis zu 0,80 mmol, bevorzugt 0,01 bis 0,75 mmol, an diesen Gruppen enthalten. Die Säure- oder Salzgruppen sind bevorzugt Carboxy-, Carboxylat-, Sulfo-, Sulfonat-, Phosphono- oder Phosphonatgruppen.

In einer besonderen Ausführungsform sind auch Polymere verwendbar, die keine oder weniger als die oben genannte Mindestmenge an Säure- oder Salzgruppen enthalten. Dann müssen die wäßrigen Dispersionen allerdings mit anionischen oberflächenaktiven Verbindungen stabilisiert sein. Diese Verbindungen enthalten bevorzugt Anionen der allgemeinen Formel

R¹O-(CH₂-CHR²-O-)ₙY

worin
- R¹: einen (C₆-C₂₀)Alkylrest oder einen gegebenenfalls (C₁-C₁₈)alkylsubstituierten (C₆-C₁₂)Arylrest,
- R²: ein Wasserstoffatom oder eine Methylgruppe,
- Y: eine SO₃⁻, CH₂-CO₂⁻ oder PO₃²⁻-Gruppe und
- n: eine ganze Zahl von 0 bis 50
bedeutet und das zugehörige Kation ein Natrium-, Kalium-, Ammonium-, Diethanolammonium- oder Triethanolammoniumion ist.

Die anionischen oberflächenaktiven Mittel können auch zusammen mit den obengenannten Polymeren mit 0,01 bis 0,80 mmol/g an Säure- und/oder Salzgruppen verwendet werden. Der Anteil der anionischen oberflächenaktiven Mittel beträgt 1 bis 20 Gew.-%, jeweils bezogen auf das Gesamtgewicht der nichtflüchtigen Bestandteile der Dispersion.

Die sprühfähige Dispersion kann zusätzlich noch nichtionische oberflächenaktive Verbindungen und/oder wasserlösliche Schutzkolloide enthalten. Geeignete nichtionische oberflächenaktive Verbindungen sind beispielsweise Verbindungen der allgemeinen Formel, in denen Y für ein Wasserstoffatom steht, R¹ zusätzlich zu den obengenannten Resten für ein Wasserstoffatom oder eine (C₁-C₅)Alkylgruppe stehen kann und n eine Zahl von mindestens 7 ist.

Der Anteil der nichtionischen oberflächenaktiven Verbindungen beträgt bis zu 10 Gew.-%, bezogen auf das Gesamtgewicht der nichtflüchtigen Bestandteile der Dispersion. Als Schutzkolloide sind insbesondere Homo- oder Copolymere des Vinylalkohols, Cellulosederivate, wie Methylcellulose, Hydroxyethylcellulose und Carboxymethylcellulose, Stärke und Stärkederivate, Gummi arabicum, Casein, Gelatine und Polyglykole geeignet. Der Anteil der Kolloide sollte nicht mehr als 30 Gew.-%, bezogen auf das Gesamtgewicht der nichtflüchtigen Bestandteile der Dispersion, betragen. Liegt der Anteil über dem angegebenen Prozentsatz, so kann es zu einer Ablösung der Mattierungsteilchen in den Bildstellen beim Entwickeln kommen.

Herstellen läßt sich das erfindungsgemäße Aufzeichnungsmaterial durch Aufsprühen der obengenannten wäßrigen Dispersion, die bevorzugt einen Anteil an nichtflüchtigen Bestandteilen von 5 bis 50 Gew.-% hat, auf die lichtempfindliche Schicht. Das Aufsprühen erfolgt nach an sich bekannten Techniken, wie Flüssigkeitsdruckzerstäubung, wozu allgemein eine Einstoffdüse verwendet wird, Luftdruckzerstäubung (Zweistoffdüse), Ultraschallzerstäubung, elektrostatisches Sprühen oder durch Sprühen mit Hilfe einer mit hoher Geschwindigkeit (ca. 20.000 Umdrehungen je Minute) rotierenden Sprühglocke, der sogenannten "Hochrotationsglocke". Zwischen Sprühglocke und dem zu mattierenden Substrat kann zusätzlich eine elektrische Spannung angelegt sein.

Die nachfolgende Trocknung erfolgt bei Temperaturen bis zu 140 °C, beispielsweise mit Hilfe von Infrarotstrahlern oder in einem Konvektionstrockner.

Die auf diese Weise aufgebrachten Mattierungspartikel liegen auf der strahlungsempfindlichen Schicht häufig in Form von mehr oder weniger abgeflachten Halbkugeln oder -ellipsoiden vor. Aufgrund ihrer Form werden die Mattierungspartikel auch als "Kalotten" bezeichnet.

Nach einer Evakuierungszeit im Vakuum-Kontaktkopierrahmen von 10 bis 60 s liegen Vorlage und Aufzeichnungsmaterial gleichmäßig aufeinander. Bei Verwendung eines Aufzeichnungsmaterials, das Kalotten mit einer Höhe von mehr als 10 µm aufweist, wird dagegen eine verschlechterte Wiedergabe von Feinzeichnungen festgestellt. Haben die Kalorien einen Durchmesser von mehr als 80 µm, können nach bildmäßigem Bestrahlen und Entwickeln noch Schichtreste in den Nichtbildbereichen verbleiben. Als vorteilhaft haben sich Kalorien mit einem Durchmesser in der Schichtebene von weniger als 40 µm, ganz besonders von weniger als 20 µm erwiesen.

Die Anzahl der Kalorien je Quadratzentimeter beträgt vorzugsweise 500 bis 5.000. Bei weniger als 100 Kalotten/cm² werden großflächige Raster häufig ungleichmäßig übertragen. Eine Anzahl von mehr als 10.000 Kalotten/cm² ist nicht nachteilig, bringt jedoch auch keine weitere Verbesserung.

Die lichtempfindliche Schicht enthält als lichtempfindliche Verbindungen Diazoniumsalze, vorzugsweise Dazoniumsalz-Polykondensationsprodukte. Als solche sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-A 20 24 244 (= US-A 3 867 147) beschrieben. Allgemein sind alle Diazoniumsalz-Polykondensationsprodukte geeignet, die in der DE-A 27 39 774 beschrieben sind.

Die Diazoniumsalzeinheiten A-N₂X leiten sich bevorzugt von Verbindungen der Formel (R³-R⁴-)ₚR⁵-N₂X ab, wobei
- X: das Anion der Diazoniumverbindung,
- p: eine ganze Zahl von 1 bis 3,
- R³: einen aromatischen Rest mit mindestens einer zur Kondensation mit aktiver Carbonylverbindung befähigten Position,
- R⁵: ein (p+1)wertiger Benzolrest,
- R⁴: eine Einfachbindung oder eine der Gruppen:
-(CH₂)_{q}-NR⁶-,
-O-(CH₂)ᵣ-NR⁶-,
-S-(CH₂)ᵣ-NR⁶-,
-S-CH₂-CO-NR⁶-,
-O-R⁷-O-,
- O -
- S - oder
-CO-NR⁶-
bedeuten, worin
- q: eine Zahl von 0 bis 5,
- r: eine Zahl von 2 bis 5,
- R⁶: Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
- R⁷: eine Arylengruppe mit 6 bis 12 C-Atomen ist.
P ist bevorzugt 1, R⁵ daher bevorzugt eine Phenylengruppe.

Weiterhin können die Diazoniumsalz-Einheiten als Seitengruppen von Polymerisaten, wie es z. B. in der US-A 4 581 313 beschrieben ist, vorliegen.

Die erfindungsgemäßen Aufzeichnungsmaterialien enthalten weiterhin ein polymeres, wasserunlösliches, in wäßrig-alkalischen Lösungen lösliches oder dispergierbares Bindemittel. Der Anteil an Diazoniumverbindung in der lichtempfindlichen Schicht liegt im allgemeinen bei 5 bis 90, bevorzugt 10 bis 70 Gew.-%, der Anteil an polymerem Bindemittel bei 10 bis 95, bevorzugt 30 bis 90 Gew.-%, bezogen auf die gesamten nichtflüchtigen Schichtbestandteile.

Beispiele für polymere Bindemittel sind Polyvinylestercopolymere, Polyvinylacetale, und Acryl-bzw. Methacrylsäureesterpolymere, welche aromatische oder aliphatische Hydroxyl-, Carbonsäure-, Sulfonsäure-, Phosphonsäure-, Säureamid- oder -imid-Einheiten enthalten. Weiterhin sind Polykondensate mit entsprechenden funktionellen Einheiten wie Phenolharze, Polyurethane oder Epoxidharze geeignet.

Besonders bevorzugte Bindemittel sind Umsetzungsprodukte eines intramolekularen Anhydrids einer organischen Polycarbonsäure mit einem Hydroxylgruppen enthaltenden synthetischen Polymeren, das keine weiteren zur Umsetzung mit Säureanhydriden befähigten funktionellen Gruppen enthält.

Das Säureanhydrid leitet sich bevorzugt von einer Di- oder Tricarbonsäure, insbesondere einer Dicarbonsäure, ab und kann einen, zwei oder mehrere Ringe enthalten.

Bevorzugt werden die Reaktionsprodukte mit Malein-, Phthal-, Bernstein- und 3-Oxa-glutarsäureanhydrid.

Als Hydroxygruppen enthaltende synthetische Polymere kommen insbesondere Polymere mit Vinylalkoholeinheiten, aber auch Epoxidharze und verseifte Epoxidharze, Copolymere von Allylalkohol oder höheren ungesättigten Alkoholen, Polyhydroxyalkylacrylate und -methacrylate und ähnliche Polymerisate in Betracht.

Als Polymere mit Vinylalkoholeinheiten sind teilverseifte Polyvinylester, Polyvinylacetale mit freien Hydroxygruppen sowie entsprechende Umsetzungsprodukte von Copolymeren bzw. Copolymerisaten mit Vinylester- oder Vinylacetal- oder Vinylalkoholeinheiten geeignet.

Das Molekulargewicht der Carboxylgruppen enthaltenden Bindemittel liegt im allgemeinen zwischen 5.000 und etwa 200.000, vorzugsweise zwischen 10.000 und 100.000. Die Säurezahl der Bindemittel kann im allgemeinen zwischen 5 und 300, bevorzugt zwischen 10 und 200 liegen. Diese bevorzugten Bindemittel sind in der EP-A 152 819 näher beschrieben.

Zur Stabilisierung der Lösung bzw. der damit erhaltenen Schicht ist es vorteilhaft, dieser eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Den Lösungen können ferner Weichmacher, Haftvermittler, Farbstoffe, Pigmente und Farbbildner zugesetzt werden.

Um die belichteten Bereiche sichtbar zu machen, kann die Schicht noch geringe Mengen an Indikatorfarbstoffen und Verbindungen, die unter der Einwirkung aktinischer Strahlung Säure bilden, enthalten. Die Säure bewirkt dann einen Farbumschlag bei einem Indikatorfarbstoff. Geeignete Säurebildner sind beispielsweise 1,2-Naphthochinon-2-diazid-4-sulfonylchlorid, chromophor substituierte Halogenmethyl-s-triazine sowie Diazoniumsalze, insbesondere Diazoniumtetrafluoroborate und Diazonium-hexafluorophosphate. Geeignete Indikatorfarbstoffe sind beispielsweise kationische Triarylmethan- oder Methin-Farbstoffe.

Soll ein Trägermaterial mit dem lichtempfindlichen Gemisch beschichtet werden, wird im allgemeinen eine Lösung des Gemischs aufgetragen. Das Lösemittel ist auf das vorgesehene Beschichtungsverfahren, die Schichtdicke und die Trocknungsbedingungen abzustimmen. Als Lösemittel geeignet sind Ketone (wie Butanon), chlorierte Kohlenwasserstoffe (wie Trichlorethylen und 1,1,1-Trichlorethan), Alkohole (wie n-Propanol), Ether (wie Tetrahydrofuran), Glykolmonoether (wie Ethylenglykol-monoalkylether und Propylenglykol-monoalkylether) und Ester (wie Butylacetat und Propylenglykol-monoalkylether-acetat). Es können auch Gemische verschiedener Lösemittel verwendet werden. In speziellen Fällen kann es vorteilhaft sein, noch weitere Lösemittel, wie Acetonitril, Dioxan, Dimethylacetamid oder Dimethylsulfoxid, mitzuverwenden. Im Prinzip sind alle Lösemittel geeignet, die mit den Bestandteilen des Gemisches nicht irreversibel reagieren. Glykol-monoalkylether, insbesondere Ethylenglykol-monomethylether und Propylenglykol-monomethylether, sind besonders bevorzugt.

Die Trägermaterialien bestehen gewöhnlich aus Metall. Lichtempfindliche Aufzeichnungsmaterialien für die Herstellung von Offsetdruckplatten haben als Trägermaterial in der Regel walzblankes, mechanisch und/oder elektrochemisch aufgerauhtes und gegebenenfalls anodisiertes Aluminium. Das Aluminium kann auch noch chemisch vorbehandelt sein, beispielsweise mit Polyvinylphosphonsäure, Silikaten, Phosphaten, Hexafluorozirkonaten oder mit hydrolysiertem Tetraethylorthosilikat.

Die Beschichtung selbst erfolgt in an sich bekannter Weise durch Aufschleudern, Aufsprühen, Eintauchen oder durch Auftragen mit Walzen, Breitschlitzdüsen, Rakeln oder Gießern.

Zur Herstellung einer Druckform wird das strahlungsempfindliche Aufzeichnungsmaterial in einem Vakuum-Kontaktkopierrahmen unter einer Filmvorlage bildmäßig bestrahlt und anschließend mit einem wäßrig-alkalischen Entwickler entwickelt. Zur Bestrahlung sind Röhrenlampen, Xenonimpulslampen, mit Metallhalogenid dotierte Quecksilberdampflampen oder Kohlenbogenlampen geeignet. Der wäßrig-alkalische Entwickler kann neben Alkalisilikaten noch geringe Mengen an Puffersubstanzen, Lösemitteln, Tensiden, Reduktionsmitteln, Entschäumern, Komplexbildnern, Korrosionsinhibitoren und/oder Hydrotropen enthalten. Er kann darüber hinaus auch noch Carbon-, Sulfon- und/oder Phosphonsäuren enthalten. Die Normalität des Alkalisilikat-Entwicklers beträgt vorzugsweise 0,2 bis 1,0 val/l. Nach dem Entwickeln kann die Druckform noch gummiert werden.

Die Erfindung wird anhand der folgenden Beispiele näher erläutert. Vergleichsbeispiele sind mit einem * gekennzeichnet. Gt bedeutet "Gewichtsteile". Prozentangaben und Mengenverhältnisse sind in Gewichtseinheiten zu verstehen. Alle anderen Abkürzungen sind nachstehend aufgeführt.
1. Kenngrößen der Dispersion
- FK: Festkörpergehalt der Dispersion (in Gew.-%)
- SG: Säure- und/oder Salzgruppengehalt (mmol/g Harz)
- TG: Glastemperatur (°C)

2. Kenngrößen der Schichttopographie
- D: mittlerer Kalottendurchmesser (µm)
- Dm: maximaler Kalottendurchmesser (µm)
- H: mittlere Höhe der Kalorien (µm)
- Hm: maximale Höhe der Kalorien (µm)
- n: Anzahl der Kalorien pro cm²

3. Prüfkriterien
T Evakuierzeit in Sekunden zur Kontaktierung Filmvorlage/Flachdruckplatte
K Kalotten in Bildstellen nach Entwicklung:
+ = vorhanden
0 = teilweise vorhanden
- = abgelöst
S Spots in Nichtbildstellen nach Entwicklung:
+ = keine Spots
- = Spots vorhanden
A Ausbrüche in Vollton-Bildstellen durch unvollständige Durchhärtung
+ = keine Ausbrüche
- = Ausbrüche feststellbar
R Rasterruhe; die Gleichmäßigkeit der Wiedergabe eines großflächigen 60er Rasters mit 20 % Flächendeckung wird visuell wie folgt bewertet:
+ = keine Ausbrüche,
0 = vereinzelt Ausbrüche, leichte Rasterunruhe,
- = viele Ausbrüche, starke Rasterunruhe,
V Lagerverhalten der lichtempfindlichen Materialien im Kontakt mit Zwischenlagepapier unter folgenden Bedingungen:

| | |
|---|---|
| Temperatur: | 40 °C |
| Relative Luftfeuchte: | 90 % |
| Druckbelastung: | 0,25 bar |
| Dauer: | 72 Stunden |

0 = Klebt am Zwischenlagepapier
- = starkes Kleben bzw. Papierfaserübertrag auf Kalotten
+ = Klebt nicht

### Beispiel 1

Eine in Salzsäure elektrolytisch aufgerauhte (R_{z}-Wert nach DIN 4768: 5,0 µm), 0,3 mm dicke Aluminiumfolie wurde mit Schwefelsäure zwischengebeizt und in Schwefelsäure anodisch oxydiert (Oxidgewicht 3,0 g/m²), mit Polyvinylphosphonsäure hydrophiliert und anschließend mit folgender Lösung beschichtet:
- 1,7 Gt: des Umsetzungsprodukts eines Polyvinylbutyrals mit einem Molekulargewicht von 70000 bis 80000, das 71 Gew.-% Vinylbutyral-, 2 Gew.-% Vinylacetat- und 27 Gew.-% Vinylalkoholeinheiten enthält, mit Propenylsulfonylisocyanat,
- 0,6 Gt: eines Diazoniumsalz-Polykondensationsprodukts aus 1 mol 3-Methoxy-diphenylamin-4-diazoniumsulfat und 1 mol 4,4'-Bis-methoxymethyl-diphenylether, ausgefällt als Mesitylensulfonat,
- 0,09 Gt: Viktoriareinblau FGA (C. I. Basic Blue 81) und
- 0,07 Gt: Phosphorsäure (85%) in
- 60 Gt: 2-Methoxy-ethanol und
- 20 Gt: Butylacetat.

Die Schicht wurde 1 Minute bei 125 °C getrocknet. Das Schichtgewicht betrug 1,0 g/m².

Anschließend wurde, elektrostatisch unterstützt, mit Hilfe einer Hochrotationsglocke die wäßrige Dispersion eines Methacrylsäure-Methylmethacrylat-Ethylacrylat-Copolymeren aufgesprüht, deren pH mit NaOH auf 10 eingestellt war.

Dispersionskenndaten:
FK = 20, anionischer Stabilisator gemäß allgemeiner Formel, in der R¹ = C₉H₁₉-Phenyl-, R² = H, n = 8 und Y = SO₃⁻ ist. Kation: Na⁺. Der Anteil an Methacrylsäure variierte bei konstantem Anteil an Ethylacrylat wie in Tabelle 1 beschrieben.

**Tabelle 1**

| Beispiel Nr. | SG | in Gew.-% Methacrylsäure | T_{g} |
|---|---|---|---|
| 1-1 | 0,18 | 1,5 | ≧ 75 °C |
| 1-2 | 0,36 | 3,0 | ≧ 75 °C |
| 1-3 | 0,53 | 4,6 | ≧ 75 °C |
| 1-4 | 0,71 | 6,1 | ≧ 75 °C |
| 1-5* | 1,43 | 12,2 | ≧ 75 °C |
| 1-6* | 2,32 | 19,9 | ≧ 75 °C |

In zwei weiteren Vergleichsbeispielen wurde einmal analog zu EP-A 174 588 eine diskontinuierliche Deckschicht durch Aufsprühen und Trocknen der für die Herstellung der lichtempfindlichen Schicht eingesetzten Beschichtungslösung erzeugt (1-7*) und ein zweites Mal keine Deckschicht aufgebracht (1-8*).

### Sprühbedingungen

| | |
|---|---|
| Abstand der Sprühglocke zum Substrat: | 15 cm |
| Glockendrehzahl: | 20000 Upm |
| Glockendurchmesser: | 6 cm |
| Potentialdifferenz: | 40 kV |
| Infrarot-Trockung | |

Aus der Bildanalyse ergaben sich folgende Werte für die Kalottenbelegung: D = 30-35 µm, Dm = 60-70, H = 3-4, Hm = 7-9 und n = 2000 bis 3000.

Die Platten wurden in einem Vakuum-Kontaktkopierrahmen mit einer 5-kW-Metallhalogenid-Quecksilberdampflampe aus einem Abstand von 110 cm 90 s auf Filmkantenfreiheit hin belichtet. Entwickelt wurde in einem Tauchbadentwicklungsgerät mit einer Bürste bei einer Verarbeitungsgeschwindigkeit von 0,8 m/min mit einer Entwicklerlösung der folgenden Zusammensetzung:
- 4 G: t Natriumpelargonat,
- 1 Gt: Ethylendiamintetra-methylenphosphonsäure-Natriumsalz`
- 1 Gt: Phenoxyethanol und
- 2 Gt: Kaliumsilikat in
- 93 Gt: Wasser

Es wurden die in Tabelle 1a wiedergegebenen Resultate erhalten.

**Tabelle 1a**

| Beispiel | T | K | S | R | A | V |
|---|---|---|---|---|---|---|
| 1-1 bis 1-4 | < 20 | + | + | + | + | + |
| 1-5* | < 20 | 0 | + | + | + | 0 |
| 1-6* | < 20 | - | + | + | + | - |
| 1-7* | < 20 | + | + | + | - | ± |
| 1-8* | > 30 | entfällt | entfällt | - | entfällt | entfällt |

Die Ergebnisse zeigen, daß nur bei den erfindungsgemäßen Materialien ein unkritisches Verhalten bei den Unterstrahlungstests nach einem Entwicklungsschritt vorliegt.

### Beispiel 2

Eine in Salzsäure elektrolytisch aufgerauhte (R_{z}-Wert nach DIN 4768: 3,2 µm), 0,3 mm dicke Aluminiumfolie wurde mit Schwefelsäure zwischengebeizt und in Schwefelsäure anodisch oxydiert (Oxidgewicht 2,0 g/m²), mit Polyvinylphosphonsäure hydrophiliert und anschließend mit folgender Lösung beschichtet:
- 1,2 Gt: des Umsetzungsprodukts des in Beispiel 1 angegebenen Polyvinylbutyrals mit Maleinsäureanhydrid (Säurezahl 30),
- 1,2 Gt: eines Diazoniumsalz-PoIykondensationsprodukts aus 3-Methoxy-diphenylamin-4-diazoniumsulfat und Formaldehyd,
- 0,02 Gt: Phenylazodiphenylamin und
- 0,3 Gt: Renolblau B2G.-H (C. I. 74 160) in
- 97,3 Gt: 2-Methoxyethanol

Die Beschichtung wurde 1 Minute bei 125 °C getrocknet. Das Schichtgewicht betrug 1,1 g/m².

Anschließend wurde, elektrostatisch unterstützt, mit einer Hochrotationsglocke die wäßrige Dispersion eines Methacrylsäure-Styrol-Ethylacrylat-Copolymeren mit einem Methacrylsäuregehalt von 0,46 mmol/g entsprechend 4 Gew.-% Methacrylsäure aufgesprüht, die mit einem KOH/NaOH-Gemisch auf pH 9,5 eingestellt war.

Dispersionskenndaten:
Tg ca. 70 °C, FK = variierte entsprechend Tabelle 2a, anionischer Stabilisator wie in Beispiel 1. Kation: Na⁺. Schutzkolloid: 10 Gew.-% Polyvinylakohol (®Mowiol 3-83 der Hoechst AG) bezogen auf FK.

### Sprühbedingungen

| | |
|---|---|
| Abstand der Sprühglocke zum Substrat: | 15 cm |
| Glockendrehzahl: | 25000 Upm |
| Glockendurchmesser: | 6 cm |
| Potentialdifferenz: | 35 kV |
| kombinierte Konvektions-/IR-Trocknung | |

Daraus resultierte die in Tabelle 2a dargestellte Kalottenbelegung.

**Tabelle 2a**

| Beispiel | FK | D | DM | H | Hm | n |
|---|---|---|---|---|---|---|
| 2-1 | 30 | < 40 | < 80 | 6 | < 10 | ca. 2000 |
| 2-2 | 25 | < 40 | < 80 | 5 | < 10 | ca. 2000 |
| 2-3 | 20 | < 40 | < 80 | 4 | < 10 | ca. 2000 |
| 2-4 | 15 | < 40 | < 80 | 3 | < 10 | ca. 2000 |
| 2-5* | 10 | < 40 | > 80 | 2 | < 10 | ca. 2000 |
| 2-6* | 5 | < 40 | > 80 | 1 | < 10 | ca. 2000 |

Als Vergleichsbeispiel 2-7* wurde eine kontinuierliche Mattierungsschicht gemäß DE-A 25 12 043 aus einer 4%igen wäßrigen Lösung von Polyvinylalkohol (K-Wert 4; 12% Restacetylgruppen), die 5 Gew.-%, bezogen auf Feststoff, Kieselsäuregel der mittleren Korngröße 5 µm enthielt, auf die lichtempfindliche Schicht aufgebracht.

Eine Testvorlage wurde auf eine Platte gelegt und in einem Vakuum-Kontaktkopierrahmen mit einer 5-kW-Metallhalogenid-Quecksilberdampflampe in einem Abstand von 110 cm 60 s belichtet. Danach wurde die Platte in einem Tauchbadentwicklungsgerät mit Bürste bei einer Verarbeitungsgeschwindigkeit von 0,6 m/min in einer Entwicklerlösung folgender Zusammensetzung entwickelt:
- 1 Gt: 1-Aminopropanol-2,
- 0,2 Gt: Na₂SiO₃ x 5 H₂O,
- 2 Gt: Natriumcumolsulfonat und
- 0,1 Gt: Nonylphenol/Ethylenoxid-Umsetzungsprodukt mit 15 Ethylenoxideinheiten je mol in
- 96,7 Gt: Wasser.

Die in Tabelle 2b wiedergegebenen Resultate zeigen das gute Verhalten der erfindungsgemäßen Aufzeichnungsmaterialien.

**Tabelle 2b**

| Beispiel | T | K | S | A | V |
|---|---|---|---|---|---|
| 2-1 bis 2-4 | < 20 | + | + | + | + |
| 2-5* | < 20 | + | 0 | + | + |
| 2-6* | 23 | + | - | + | + |
| 2-7* | < 20 | - | + | + | - |

### Beispiel 3

Eine Aluminiumfolie gemäß Beispiel 1 wurde mit folgender Lösung beschichtet:
- 2,1 Gt: des Umsetzungsprodukts des in Beispiel 1 angegebenen Polyvinylbutyrals mit Trimellithsäureanhydrid (Säurezahl 90),
- 0,6 Gt: des in Beispiel 1 angegebenen Diazoniumsalz-Polykondensationsprodukts,
- 0,06 Gt: Phosphorsäure (85%) und
- 0,3 Gt: Kupferphthalocyanin in
- 96,9 Gt: 2-Methoxyethanol.

Die Beschichtung wurde 1 min bei 125 °C getrocknet. Das Schichtgewicht betrug 1,4 g/m².

Anschließend wurde mit einer Hochrotationsglocke, elektrostatisch unterstützt, unter den in Beispiel 2 angegebenen Sprühbedingungen
a) eine wäßrige Dispersion eines Zink-Ammoniak-Komplex-Salzes eines Methacrylsäure-Styrol-Ethylacrylat-Copolymeren mit einer Teilchengröße unterhalb 100 nm und
b) als Vergleich gemäß EP-A 92 794 eine wäßrige Lösung eines Polymeren der Styrol-4-sulfonsäure (Natriumsalz) mit einem Molekulargewicht von 20000, FK 20 %,
aufgesprüht, wobei durch Variation der Beschichtungsgeschwindigkeit (Tabelle 3a) unterschiedliche Kalottenbelegungen erhalten wurden.

Dispersionskenndaten:
Tg ca. 75 °C, FK = 20, anionischer Stabilisator gemäß allgemeiner Formel mit R¹ = C₈H₁₇-, R² = H, n = 3 und Y = PO₃²⁻, nicht-ionischer Stabilisator mit R¹ = C₁₆H₃₃, R² = H, n = 50, Y = H; Säuregehalt 0,53 mmol/g entsprechend 4,6 Gew.-% Methacrylsäure.

**Tabelle 3a**

| Beispiel | Deckschicht | D | Dm | H | Hm | n |
|---|---|---|---|---|---|---|
| 3-1 | a | < 20 | < 80 | 3 | < 10 | ca. 30 |
| 3-2 | a | < 20 | < 80 | 3 | < 10 | ca. 100 |
| 3-3 | a | < 20 | < 80 | 3 | < 10 | ca. 500 |
| 3-4 | a | < 20 | < 80 | 3 | < 10 | ca. 1000 |
| 3-5 | a | < 20 | < 80 | 3 | < 10 | ca. 9000 |
| 3-6 | a | < 20 | < 80 | 3 | < 10 | ca. 25000 |
| 3-1 | b* | < 20 | < 80 | 3 | < 10 | ca. 30 |
| 3-2 | b* | < 20 | < 80 | 3 | < 10 | ca. 100 |
| 3-3 | b* | < 20 | < 80 | 3 | < 10 | ca. 500 |
| 3-4 | b* | < 20 | < 80 | 3 | < 10 | ca. 1000 |
| 3-5 | b* | < 20 | < 80 | 3 | < 10 | ca. 9000 |
| 3-6 | b* | < 20 | < 80 | 3 | < 10 | ca. 25000 |

Die Platten wurden in einem Vakuum-Kontaktkopierrahmen durch Evakuierung mit einer Negativvorlage kontaktiert und mit einer 5-kW-Metallhalogenid-Quecksilberdampflampe in einem Abstand von 110 cm 25 s belichtet und dann in einem Tauchbadentwicklungsgerät mit Bürste bei einer Verarbeitungsgeschwindigkeit von 0,6 m/min in der Entwicklerlösung mit folgender Zusammensetzung entwickelt:
- 1 Gt: Nitrilotris-methylphosphonsäure,
- 1 Gt: Kaliummetasilikat (K₂O:SiO₂ = 1:3),
- 1 Gt: NaOH,
- 1 Gt: Phenoxypropanol und
- 0,1 Gt: sek.-Alkansulfonat,
- 0,1 Gt: Fettalkoholpolyoxyethylenether in
- 95,8 Gt: Wasser

Die Ergebnisse zeigt Tabelle 3b.

**Tabelle 3b**

| Beispiel | Deckschicht | T | K | S | R | A | V |
|---|---|---|---|---|---|---|---|
| 3-1 | a | < 20 | + | + | 0 | + | + |
| 3-2 | a | < 20 | + | + | + | + | + |
| 3-3 | a | < 20 | + | + | + | + | + |
| 3-4 | a | < 20 | + | + | + | + | + |
| 3-5 | a | < 20 | + | + | + | + | + |
| 3-6 | a | < 20 | + | + | + | + | + |
| 3-1 | b* | < 20 | - | + | 0 | + | - |
| 3-2 | b* | < 20 | - | + | 0 | + | - |
| 3-3 | b* | < 20 | - | + | + | + | - |
| 3-4 | b* | < 20 | - | + | + | + | - |
| 3-5 | b* | < 20 | - | + | + | + | - |
| 3-6 | b* | < 20 | - | + | + | + | - |

### Beispiel 4

Eine 0,4 mm dicke Aluminiumfolie wurde zunächst in einer Bimsmehlsuspension mechanisch und anschließend in Salzsäure elektrolytisch aufgerauht (Rz-Wert nach DIN 4768: 6,0 µm), dann in Schwefelsäure zwischengebeizt und anodisch oxydiert (Oxidgewicht 4,0 g/m²), mit Polyvinylphosphonsäure hydrophiliert und mit folgender Lösung beschichtet:
- 1,8 Gt: eines Copolymeren aus Methacrylsäure, Methylmethacrylat und 2-Hydroxyethylmethacrylat (20:30:50) mit einem Molekulargewicht von 20000,
- 0,5 Gt: des in Beispiel 1 angegebenen Diazoniumsalz-Polykondensationsprodukts,
- 0,09 Gt: Viktoriareinblau FGA und
- 0,07 Gt: Phosphorsäure (85%) in
- 60 Gt: 2-Methoxy-ethanol und
- 20 Gt: Butylacetat.

Die Schicht wurde 1 Minute bei 125 °C getrocknet. Das Schichtgewicht betrug 1,5 g/m².

Anschließend wurden mittels Hochrotationsglocke mit elektrostatischer Unterstützung wäßrige Dispersionen der folgenden Polymeren aufgesprüht:

### Beispiel

**4-1:**
   Copolymeres aus 80 % Vinylidenchlorid, 5 % Acrylnitril, 12 % Methylmethacrylat und 3 % Acrylsäure (entsprechend 0,42 mmol/g); Stabilisator: Dodecylbenzolsulfonat, FK = 20
**4-2:**
   Copolymeres aus Styrol, Butylacrylat und Natriumethensulfonat mit einem Sulfonatgehalt von 0,43 mmol/g; kein zusätzlicher Stabilisator, FK = 20
**4-3:**
   Copolymeres wie bei 4-2; Stabilisator: Hydroxyethylcellulose` 10 % bezogen auf FK = 18
   sowie als Vergleich entsprechend EP-A 174 588 (4-4*) die strahlungsempfindliche Beschichtungslösung.

Sprühbedingungen:
Abstand Sprühglocke - Substrat 15 cm,
Glockendrehzahl 30000 Upm, Glockendurchmesser 6 cm,
Potentialdifferenz 35 kV, IR-Trocknung.

Dabei wurde die folgende Kalottenbelegung erhalten: (Werte aus Bildanalyse) D = 25-35, Dm = 40-50, H = 3-4, Hm = 8-10, n = 1500-2500.

Die Platten wurden in einem Vakuum-Kontaktkopierrahmen mit einer metallhalogenid-dotierten 5 kW-Quecksilberdampflampe im Abstand von 110 cm 35 s belichtet. Entwickelt wurde in einem Tauchbadentwicklungsgerät mit Bürste bei einer Verarbeitungsgeschwindigkeit von 0,8 m/min in dem Entwickler aus Beispiel 1.

Es wurden die in der Tabelle 4 wiedergegebenen Resultate erhalten.

**Tabelle 4**

| Beispiel | T | K | S | R | A | V |
|---|---|---|---|---|---|---|
| 4-1 | < 20 | + | + | + | + | + |
| 4-2 | < 20 | + | + | + | + | + |
| 4-3 | < 20 | + | + | + | + | + |
| 4-4* | < 20 | + | + | + | - | + |

## Patentansprüche

1. Lichtempfindliches Aufzeichnungsmaterial mit einem Schichtträger, einer negativ arbeitenden lichtempfindlichen Schicht, die ein Diazoniumsalz und ein wasserunlösliches, in wäßrig-alkalischen Lösungen lösliches oder quellbares polymeres Bindemittel enthält, und einer diskontinuierlichen, eine rauhe Oberfläche bildenden Deckschicht, dadurch gekennzeichnet, daß die Deckschicht aus Partikeln eines wasserunlöslichen, in Wasser in Gegenwart von anionischen oder anionisch/nichtionischen Dispergiermitteln dispergierbaren Polymeren mit einem Gehalt an freien oder durch Salzbildung neutralisierten Säuregruppen von weniger als 0,8 mmol/g besteht, wobei die mittlere Höhe der Partikel 2 bis 6 µm, die maximale Höhe kleiner als 10 µm, der mittlere horizontale Durchmesser kleiner als 40 µm, der maximale Durchmesser kleiner als 80 µm ist und die Anzahl der Partikel 100 bis 10000 je cm² beträgt.

2. Lichtempfindliches Aufzeichnungsmaterial nach Anspruch 1, dadurch gekennzeichnet, daß die Säuregruppen Carbonsäure-, Sulfonsäure- oder Phosphonsäuregruppen sind.

3. Lichtempfindliches Aufzeichnungsmaterial nach Anspruch 1, dadurch gekennzeichnet, daß das Polymere einen Säuregruppengehalt von 0,01 bis 0,75 mmol/g aufweist.

4. Lichtempfindliches Aufzeichnungsmaterial nach Anspruch 1, dadurch gekennzeichnet, daß das Polymere ein Polyester, Polyamid, Polyurethan, Polyharnstoff, ein Copolymeres der Acryl-, Methacryl-, Itacon-, Malein-, Vinylsulfon- oder Styrylsulfonsäure ist.

5. Lichtempfindliches Aufzeichnungsmaterial nach Anspruch 1, dadurch gekennzeichnet, daß das Diazoniumsalz ein Polykondensationsprodukt ist.

6. Verfahren zur Herstellung eines lichtempfindlichen Aufzeichnungsmaterials aus einem Schichtträger und einer negativ arbeitenden lichtempfindlichen Schicht und einer diskontinuierlichen, eine rauhe Oberfläche bildenden Deckschicht, dadurch gekennzeichnet, daß man auf die negativ arbeitende lichtempfindliche Schicht eine anionisch oder anionisch/nichtionisch stabilisierte wäßrige Dispersion eines wasserunlöslichen Polymeren mit einem Gehalt an freien oder durch Salzbildung neutralisierten Säuregruppen von weniger als 0,8 mmol/g aufsprüht und trocknet.

7. Verfahren nach Anspruch 6, dadurch gekennzeichnet, daß man die Dispersion unter elektrostatischer Unterstützung aufsprüht.

8. Verfahren nach Anspruch 6, dadurch gekennzeichnet, daß die Dispersion durch Zusatz einer anionischen oberflächenaktiven Verbindung der allgemeinen Formel
R¹O-(CH₂-CHR²-O-)ₙY
stabilisiert ist, worin
R¹ einen (C₆-C₂₀)Alkylrest oder einen gegebenenfalls (C₁-C₁₈)alkylsubstituierten (C₆-C₁₂)Arylrest,
R² ein Wasserstoffatom oder eine Methylgruppe,
Y eine SO₃⁻-, CH₂-CO₂⁻ oder PO₃²⁻-Gruppe und
n eine ganze Zahl von 0 bis 50
bedeutet und das zugehörige Kation ein Natrium-, Kalium-, Ammonium-, Diethanolammonium- oder Triethanolammoniumion ist.

9. Verfahren nach Anspruch 6, dadurch gekennzeichnet, daß die Dispersion 5 bis 50 Gew.-% nichtflüchtige Bestandteile enthält.
